# EUROPEAN PATENT APPLICATION

(11) **EP 2 682 443 A1**
(43) Date of publication of application: **08.01.2014**
(21) Application number: 12751824.9
(22) Date of filing: 01.03.2012
(51) Int. Cl.: C09J 175/04, B32B 27/30, B32B 27/40, C09J 11/06, H01L 31/042

(54) **ADHESIVE COMPOSITION, LAMINATED BODY, AND SOLAR BATTERY MODULE**

(30) Priority: 03.03.2011 JP 2011046184
(71) Applicant: Asahi Glass Company, Limited, Tokyo 100-8405 (JP)
(72) Inventor: ARUGA, Hiroshi, Tokyo 100-8405 (JP); ODA, Koichi, Tokyo 100-8405 (JP); MIYAJIMA, Tatsuya, Tokyo 100-8405 (JP)
(74) Representative: Müller-Boré & Partner Patentanwälte
(86) International application number: PCT/JP2012/055278
(87) International publication number: WO 2012/118160

(57) **Abstract**

To provide an adhesive composition capable of forming an adhesive layer that can maintain a high adhesive force and an excellent ultraviolet absorbing function over a long period of time, a laminate having an adhesive layer formed of the adhesive composition, and a solar cell module having such a laminate. An adhesive composition comprising a polyurethane resin made from a polycarbonate polyol, a curing agent, a triazine-type ultraviolet absorber and a light stabilizer. Further, a laminate 10 having a first substrate 11, an adhesive layer 12 formed of the adhesive composition and a second substrate 13 laminated in this order. A solar cell module having the laminate 10 as at least one of a front surface material or a rear surface material.

## Description

### TECHNICAL FIELD

The present invention relates to an adhesive composition, a laminate and a solar cell module.

### BACKGROUND ART

A fluororesin film has an excellent weather resistance and can well maintain the transparency and mechanical strength even when subjected to, for example, outdoor exposure for 10 years. Therefore, it is used as a protective film to be laminated on the surface of various printed matters or displays. Further, in recent years, in place of glass, it has been used as a surface material for solar cell modules. The surface material using a fluororesin film is produced by a lamination method wherein a fluororesin film is hot-pressed at a temperature of from 140°C to 160°C directly on an ethylene/vinyl acetate copolymer (EVA) film to protect a solar cell or on a polyethylene sheet having adhesion improved, without using an adhesive. However, such a surface material is inferior in the steam shielding property as compared with a surface material using glass, since the steam shielding property (the steam barrier property) of the fluororesin film is inadequate.

Therefore, it has been proposed to laminate, as a steam barrier film, a polyethylene terephthalate (PET) film, a polyethylene naphthalate (PEN) film or a polyethylene (PE) film on the fluororesin film being a surface material. However, the weather resistance of a film such as a PET film having a steam barrier property is at a level of 2 years, and it is required to block ultraviolet light in order to increase the weather resistance. Therefore, it has been proposed to impart an ultraviolet absorbing property to an adhesive composition to be used for laminating a PET film on a fluororesin film, for example, to use an adhesive composition containing an ultraviolet absorber and EVA (Patent Documents 1 and 2).

Further, as a rear surface material for a solar cell, a rear surface material has been proposed wherein on at least one surface of a transparent fluororesin film, at least an inorganic oxide layer, an adhesive layer and an electrically insulating layer are sequentially laminated, and for the purpose of improving the weather resistance, an organic ultraviolet absorber is incorporated to the adhesive layer in an amount of at least 0.1 part by mass and at most 10 parts by mass, per 100 parts by mass of the resin solid content constituting the adhesive layer (Patent Document 3). For the adhesive layer of this rear surface material, an adhesive composition is used which comprises a polyurethane type adhesive and a triazole type organic ultraviolet absorber.

These adhesive compositions are required to maintain a stabilized adhesion state over a long period of time and at the same time to maintain a high ultraviolet absorbing function. Particularly in an application to a front surface material or a rear surface material for a solar cell, it is important that it is possible to reduce a color change or a decrease in the adhesive force for at least 1000 hours in a weather-o-meter test or in a damp heat test at 85°C under a relative humidity of 85%.

Further, other than the application to a solar cell, the following ones are disclosed as laminates wherein an ultraviolet absorbing adhesive layer is formed on a fluororesin film.

Patent Document 4 discloses a building base material wherein a tetrafluoroethylene copolymer resin film and a vinyl chloride type resin film are laminated via at least an ultraviolet absorbing acrylic resin layer (Patent Document 4). As the ultraviolet absorbing acrylic resin, a copolymer of an acrylic monomer having a polymerizable unsaturated group with a reactive benzophenone type compound or a reactive benzotriazole type compound having an ultraviolet absorbing ability, is used.

Patent Document 5 discloses a surface protective film wherein a covering layer composed mainly of the above-mentioned ultraviolet absorbing acrylic resin and heat adhesive resin, is formed on a resin film composed mainly of an ethylene/tetrafluoroethylene copolymer.

### PRIOR ART DOCUMENTS

### PATENT DOCUMENTS

Patent Document 1: Japanese Patent No. 3,978,912
Patent Document 2: Japanese Patent No. 3,530,595
Patent Document 3: JP-A-2008-270647
Patent Document 4: JP-A-1 0-205056
Patent Document 5: Japanese Patent No. 3,718,901

### DISCLOSURE OF INVENTION

### TECHNICAL PROBLEM

However, with adhesive compositions as disclosed in Patent Documents 1 and 2, the ultraviolet absorber volatilizes from EVA as time passes, whereby a PET film or the like tends to be deteriorated and colored by ultraviolet light to lower the conversion efficiency of a solar cell. Further, the adhesion is also likely to decrease.

Whereas, the adhesive compositions used in Patent Documents 3 to 5 are inadequate in the weather resistance, whereby the adhesive force and the ultraviolet absorbing function cannot be maintained for a long period of time.

It is an object of the present invention to provide, as an adhesive composition which can be used for e.g. solar cells, an adhesive composition capable of forming an adhesive layer that can maintain a high adhesive force and an excellent ultraviolet-absorbing function for a long period of time.

Further, it is an object of the present invention to provide a laminate having an adhesive layer formed of the above adhesive composition, laminated on a substrate made of a resin film such as a fluororesin film, and thus being capable of maintaining a high adhesive force and an excellent ultraviolet-absorbing function for a long period of time, and a solar cell module employing such a laminate.

### SOLUTION TO PROBLEM

In order to solve the above problems, the present invention has adopted the following constructions.
[1] An adhesive composition comprising a polyurethane resin (A) made from a polycarbonate polyol (a1), a curing agent (B), a triazine-type ultraviolet absorber (C) and a light stabilizer (D).
[2] The adhesive composition according to [1], wherein the curing agent (B) includes an isocyanurate.
[3] The adhesive composition according to [1] or [2], wherein the triazine-type ultraviolet absorber (C) includes a hydroxyphenyltriazine type ultraviolet absorber.
[4] The adhesive composition according to [3], wherein the hydroxyphenyltriazine type ultraviolet absorber includes 2-(2-hydroxy-4-[1-octyloxycarbonylethoxy]phenyl)-4,6-bis(4-phenylphenyl)-1,3,5-triazine.
[5] The adhesive composition according to any one of [1] to [4], wherein the light stabilizer (D) includes a hindered amine type light stabilizer.
[6] The adhesive composition according to any one of [1] to [5], wherein the equivalent ratio NCO/OH of isocyanate groups in the curing agent (B) to hydroxy groups in the polyurethane resin (A) is from 1.0 to 5.0.
[7] The adhesive composition according to any one of [1] to [6], wherein the content of the triazine-type ultraviolet absorber (C) is from 4 to 11 parts by mass per 100 parts by mass of the solid content of the polyurethane resin (A).
[8] The adhesive composition according to any one of [1] to [7], wherein the content of the light stabilizer (D) is from 0.2 to 5 parts by mass per 100 parts by mass of the solid content of the polyurethane resin (A).
[9] A laminate comprising a substrate made of a fluororesin film, and an adhesive layer formed of the adhesive composition as defined in any one of [1] to [8], on the substrate.
[10] The laminate according to [9], wherein the fluororesin film is an ethylene/tetrafluoroethylene copolymer film.
[11] A solar cell module having the laminate as defined in [9] or [10], as at least one of a front surface material and a rear surface material.

### ADVANTAGEOUS EFFECTS OF INVENTION

The adhesive composition of the present invention is capable of forming, as an adhesive composition which can be used for e.g. solar cells, an adhesive layer that can maintain a high adhesive force and an excellent ultraviolet-absorbing function for a long period of time.

Further, the laminate of the present invention has an adhesive layer formed of the adhesive composition of the present invention laminated on a substrate made of a resin film such as a fluororesin film, whereby it is capable of maintaining a high adhesive force and an excellent ultraviolet-absorbing function for a long period of time.

Further, the solar module of the present invention has the laminate of the present invention, whereby the excellent weather resistance can be maintained for a long period of time.

### BRIEF DESCRIPTION OF DRAWINGS

Fig. 1 is a cross-sectional view illustrating one embodiment of the laminate of the present invention.
Fig. 2 is a cross-sectional view illustrating one embodiment of the solar cell module of the present invention.

### DESCRIPTION OF EMBODIMENTS

In this specification, unless otherwise specified, a compound represented by the formula (1) is shown by a compound (1), and the same applies to other formulae.

### <Adhesive composition>

The adhesive composition of the present invention comprises a polyurethane resin (A) made from a polycarbonate polyol (a1), a curing agent (B), a triazine-type ultraviolet absorber (C) (hereinafter sometimes referred to simply as "ultraviolet absorber (C)") and a light stabilizer (D).

### [Polyurethane resin (A)]

The polyurethane resin (A) is a polyurethane resin made from a polycarbonate polyol (a1) as a starting material.

The polyurethane resin (A) is preferably a polyurethane resin (A1) obtainable by reacting a polycarbonate polyol (a1), an alkylene diol chain extender (a2) (hereinafter sometimes referred to as "chain extender (a2)") and an organic diisocyanate (a3), or a polyurethane resin (A2) obtainable by reacting a polycarbonate polyol (a1) and an organic diisocyanate (a3).

The polycarbonate polyol (a1) may be a polycarbonate polyol obtainable by a reaction of a diol with a short chain dialkyl carbonate.

The short chain dialkyl carbonate may, for example, be a dialkyl carbonate having a C₁₋₄ alkyl group, such as dimethyl carbonate or diethyl carbonate.

The short chain dialkyl carbonate to be used for forming the polycarbonate polyol (a1) may be of one type only or of two or more types. Further, the alkyl group which the polycarbonate polyol (a1) has, may have a straight chain structure or a branched chain structure.

The diol to be used for forming the polycarbonate polyol (a1) is preferably a diol having a branched alkyl side chain, since the adhesive strength is thereby improved. Such a diol having a branched alkyl side chain may, for example, be 2-methyl-1,3-propane diol, 3-methyl-1,5-pentane diol, 2,4-diethyl-1,5-pentane diol or 2-butyl-2-ethyl-1,3-propane diol.

Further, other than the above diol having a branched alkyl side chain, a diol having no branched alkyl side chain, such as ethylene glycol, propylene glycol, 1,4-butane diol, 1,5-pentane diol or 1,6-hexane diol may be used.

The diol to be used for forming the polycarbonate polyol (a1) may be of one type only or of two or more types.

The number of moles of units derived from the diol having the above branched alkyl side chain to the total number of moles of units derived from diols in the polycarbonate polyol (a1) is preferably at least 20 mol%, more preferably at least 30 mol%. When the number of moles of units derived from the diol having the above branched alkyl side chain is at least the lower limit value, the adhesive strength will be improved.

The weight average molecular weight of the polycarbonate polyol (a1) is preferably from 400 to 8,000, more preferably from 700 to 5,000. When the weight average molecular weight is at least the lower limit value, the solubility in a practically useful solvent will be better. On the other hand, when the weight average molecular weight is at most the upper limit value, an adequate adhesive strength tends to be readily obtainable, and the practical efficiency will be improved.

The hydroxy value of the polycarbonate polyol (a1) is preferably from 14 to 280 mg/KOH, more preferably from 22 to 160 mg/KOH. When the hydroxy value of the polycarbonate polyol (a1) is at least the lower limit value, the cross-linking reaction tends to sufficiently proceed, the molecular weight distribution of the product tends to be narrow, and the hydrolysis resistance after the curing will be better. Further, when the hydroxy value of the polycarbonate polyol (a1) is at most the upper limit value, a high molecular weight product is less likely to be formed in the cross-linking reaction, and an adhesive layer having a flexibility to follow the fluororesin film tends to be readily formed.

The chain extender (a2) may be the same diol as mentioned as a diol to form the polycarbonate polyol (a1), and is preferably a diol having a branched alkyl side chain, whereby the adhesive strength will be improved.

The molecular weight of the chain extender (a2) is preferably from 62 to 400. Among them, preferred examples may be ethylene glycol, propylene glycol, 1,4-butane diol, 1,5-pentane diol, 1,6-hexane diol, 2-methyl-1,3-propane diol, 3-methy-1,5-pentane diol, 2,4-diethyl-1,5-pentane diol and 2-butyl-2-ethy-1,3-propane diol.

The number of moles of units derived from the diol having the above branched alkyl side chain to the total number of moles of units derived from diols in the chain extender (a2) is preferably at least 5 mol%, more preferably at least 20 mol%. The number of moles of units derived from the diol having the above branched alkyl side chain is at least the lower limit value, the adhesive strength will be improved.

The organic diisocyanate (a3) may, for example, be the following ones.

An aromatic diisocyanate (such as diphenylmethane diisocyanate, tetramethylxylylene diisocyanate or tolylene diisocyanate, or a prepolymer of such an aromatic diisocyanate with a low molecular weight glycol),
an aliphatic diisocyanate (such as 1,6-hexamethylene diisocyanate, 2,2,4-trimethylhexamethylene diisocyanate, xylylene diisocyanate or lysine diisocyanate, or a prepolymer of such an aliphatic diisocyanate with a low molecular weight glycol such as ethylene glycol or propylene glycol),
an alicyclic diisocyanate (such as isophorone diisocyanate, hydrolyzed 4,4'-diphenymethane diisocyanate, methylcyclohexylene diisocyanate or isopropylidenedicyclohexyl-4,4'-diisocyanate, or a prepolymer of such an alicyclic diisocyanate with a low molecular weight glycol), and
a mixture of two or more of them.

Among them, an aliphatic or alicyclic diisocyanate such as hydrolyzed 4,4'-diphenylmethane diisocyanate, isophorone diisocyanate or 2,2,4-trimethylhexamethylene diisocyanate is preferred as the organic diisocyanate (a3), since it is excellent in the weather resistance.

The polyurethane resin (A) preferably has hydroxy groups at its terminals.

In the polyurethane resin (A1), the equivalent ratio (NCO/OH) of isocyanate groups in the organic diisocyanate (a3) to hydroxy groups in the polycarbonate polyol (a1) and the chain extender (a2) is preferably from 0.7 to 0.99, more preferably from 0.8 to 0.97. When such NCO/OH is at least the lower limit value, the adhesive strength and the heat resistance will be improved. Further, when such NCO/OH is at most the upper limit value, the base resin having a sufficient amount of hydroxyl groups at its terminals can easily be obtained.

In the case of the polyurethane resin (A1), the amount of the chain extender (a2) to be used, is preferably from 0.5 to 50 parts by mass per 100 parts by mass of the polycarbonate polyol (a1). When the amount of the chain extender (a2) to be used, is at least the lower limit value, the adhesive strength will be improved. When the amount of the chain extender (a2) to be used, is at most the upper limit value, the solubility in the synthetic solvent which will be described hereinafter, will be improved.

In the polyurethane resin (A2), the equivalent ratio NCO/OH of isocyanate groups in the organic diisocyanate (a3) to hydroxy groups in the polycarbonate polyol (a1) is preferably from 0.7 to 0.99. When such NCO/OH is at least the lower limit value, the adhesive strength and the heat resistance will be improved. Further, when such NCO/OH is at most the upper limit value, the base resin having a sufficient amount of hydroxyl groups at its terminals can easily be obtained.

The hydroxy value of the polyurethane resin (A) is preferably from 3 to 20 mg/KOH, more preferably from 5 to 10 mg/KOH. When the hydroxy value of the polyurethane resin (A) is at least the lower limit value, the cross-linking reaction with an isocyanate to be used as a two-pack curing agent can be expected. When the hydroxy value of the polyurethane resin (A) is at most the upper limit value, the cross-linking reaction with an isocyanate to be used as a two-pack curing agent tends to take place in a relatively short time and uniformly.

The weight average molecular weight of the polyurethane resin (A) is preferably from 4,000 to 50,000, more preferably from 8,000 to 15,000. When the weight average molecular weight of the polyurethane resin (A) is at least the lower limit value, the adhesive strength will be improved. On the other hand, when the weight average molecular weight of the polyurethane resin (A) is at most the upper limit value, the solubility in the synthetic solvent which will be described hereinafter, will be improved, and the processability will be better.

The reaction of the polycarbonate polyol (a1), the chain extender (a2) and the organic diisocyanate (a3) may be carried out in the absence of any solvent or may be carried out in a synthetic solvent not reactive with an isocyanate group. Further, as the case requires, the reaction may be carried out in the presence of a catalyst. The reaction temperature is preferably from 60 to 150°C. The reaction time is preferably from 2 to 15 hours.

The synthetic solvent not reactive with an isocyanate group may, for example, be an ester such as ethyl acetate, butyl acetate or cellosolve acetate; a ketone such as acetone, methyl ethyl ketone, isobutyl ketone or cyclohexanone; an ether such as tetrahydrofuran or dioxane; an aromatic hydrocarbon such as toluene or xylene; a halogenated hydrocarbon such as methylene chloride or ethylene chloride; dimethyl sulfoxide or dimethyl sulfonamide. Such a synthetic solvent may also be used as a diluting solvent after the synthesis of the base resin.

One of the polyurethane resins (A) may be used alone, or two or more of them may be used in combination.

### [Curing agent (B)]

The curing agent (B) may, for example, be a polyisocyanate. The polyisocyanate may, for example, be one having at least two isocyanate groups in one molecule, such as an adduct of a diisocyanate as mentioned for the organic diisocyanate (a3) to a polyol, or an isocyanurate, burette or allophanate of a diisocyanate as mentioned for the organic diisocyanate (a3).

Specifically, it may, for example, be a polyfunctional organic polyisocyanate such as an adduct obtainable by adding 3 mol of a diisocyanate to 1 mol of trimethylolpropane, a burette obtainable by reacting 3 mol of a diisocyanate with 1 mol of water, or an isocyanurate obtainable by polymerization of 3 mol of a diisocyanate.

As the curing agent (B), preferred is an isocyanurate containing an isocyanurate ring structure and having an isocyanate group-content of from 10 mass% to 28 mass%.

As the curing agent (B), particularly preferred is a nurate of isophorone diisocyanate (IPDI) and/or hexamethylene diisocyanate (HDI).

The curing agent (B) may be a blocked isocyanate having an isocyanate group blocked. Blocking of the isocyanate group can be carried out by e.g. epsilon caprolactam (E-CAP), methyl ethyl ketone oxime (MEK-OX), methyl isobutyl ketone oxime (MIBK-OX), pyralidine or triazine (TA).

One of such curing agents (B) may be used alone, or two or more of them may be used in combination.

### [Ultraviolet absorber (C)]

The ultraviolet absorber (C) is a triazine type ultraviolet absorber. As the ultraviolet absorber (C), a triazine derivative known as an ultraviolet absorber may be used, and it may be available from commercial products. As the ultraviolet absorber (C), a hydroxyphenyltriazine type ultraviolet absorber is preferred. As the hydroxyphenyltriazine type ultraviolet absorber, the following ultraviolet absorbers may, for example, be mentioned.
2-(2-hydroxy-4-[1-octyloxycarbonylethoxy]phenyl)-4,6-bis(4-phenylphenyl)-1,3,5-triazine (as commercial product, trade name "TINUVIN 479", manufactured by Ciba Japan K.K. (BASF Japan Ltd. as from March 1, 2010, the same applies hereinafter))
4-bis[2-hydroxy-4-butoxyphenyl]-6-(2,4-dibutoxyphenyl)-1,3,5-triazine (the following compound (1); as commercial product, trade name "TINUVIN 460", manufactured by Ciba Japan K.K.)
2-[4-[(2-hydroxy-3-(2'-ethyl)hexyloxy]-2-hydroxyphenyl]-4,6-bis(2,4-dimethylphenyl)-1,3,5-triazine (the following compound (2); as commercial product, trade name "TINUVIN 405", manufactured by Ciba Japan K.K.)
Trade name "TINUVIN 477", manufactured by Ciba Japan K.K. (a mixture comprising about 80 mass% of a hydroxyphenyltriazine type ultraviolet absorber and about 20 mass% of 1-methoxy-2-propylacetate, as disclosed at page 10 of "Catalog of additives for coating materials" (Pub. No. CJ-005, published in March 2008) by Ciba Japan K.K.)
Trade name "TINUVIN 400", manufactured by Ciba Japan K.K. (the following compound (3) obtainable by a reaction of 2-(4,6-bis(2,4-dimethylphenyl)-1,3,5-triazin-2-yl)- 5-hydroxyphenyl and a [(alkyloxy)methyl]oxirane having a C₁₀₋₁₆, mainly C₁₂₋₁₃, alkyl group, as disclosed at page 7 of the above "Catalog of additives for coating materials"), etc.

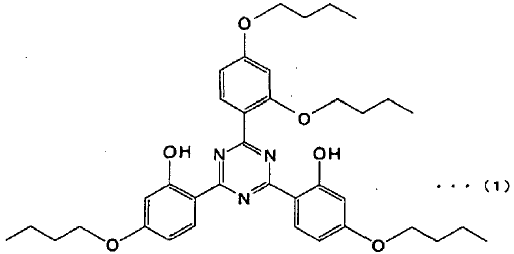

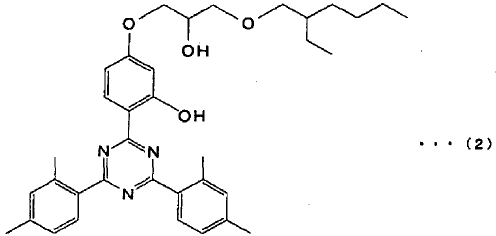

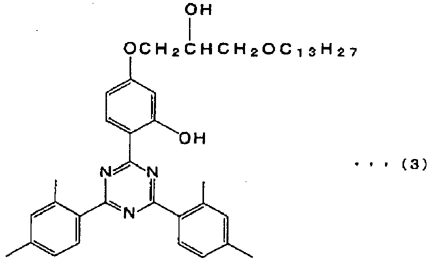

Further, as preferred ultraviolet absorbers (C) other than the hydroxyphenyltriazine type ultraviolet absorber, the following compounds may, for example, be mentioned.
2-[4,6-bis(2,4-dimethylphenyl)-1,3,5-triazin-2-yl]-5-(octyloxy)phenol (as commercial product, trade name "CYASORB UV-1164", manufactured by Sun Chemical Company Ltd.)
2-[2,6-di(2,4-xylyl)-1,3,5-triazin-2-yl]-5-octyloxyphenol (as commercial product, trade name "KEMISORB 102", manufactured by Chemipro Kasei Corporation), etc.

As the ultraviolet absorber (C), preferred is 2-(2-hydroxy-4-[1-octyloxycarbonylethoxy]phenyl)-4,6-bis(4-phenylphenyl)-1,3,5-triazine, since it is excellent in the heat resistance and is less likely to volatilize.

One of such ultraviolet absorbers (C) may be used alone, or two or more of them may be used in combination.

### [Light stabilizer (D)]

As the light stabilizer (D), a known light stabilizer may be used, and it may be available from commercial products. As the light stabilizer (D), a hindered amine type light stabilizer or a hindered phenol type light stabilizer is preferred, and a hindered amine type light stabilizer is more preferred.

As the hindered amine type light stabilizer, the following ones may, for example, be mentioned.

Bis(1,2,2,6,6-pentamethyl-4-piperidyl)[[3,5-bis(1,1-dimethylethyl)-4-hydroxyphenyl]methyl]butyl malonate (the following compound (4); as commercial product, trade name "TINUVIN 144", manufactured by Ciba Japan K.K.)

Trade name "TINUVIN 123", manufactured by Ciba Japan K.K.; a reaction product of decanedioic acid bis(2,2,6,6-tetramethyl-1-(octyloxy)-4-piperidinyl) ester (1,1-dimethylethylhydroperoxide) and octane (the following compound (5)), as disclosed at page 16 of the above "Catalog of additives for coating materials"), etc.

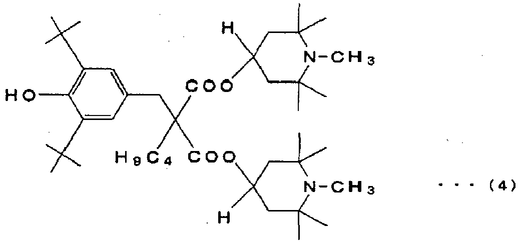

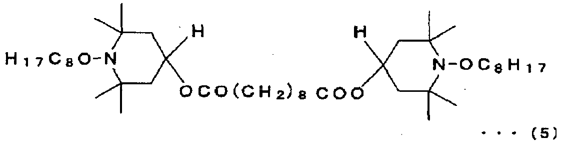

The hindered phenol type light stabilizer may, for example, be pentaerythritol-tetrakis-[3-(3',5'-di-t-butyl-4'-hydroxypheny) propionate] (the following formula (6); as commercial product, trade name "IRGANOX 1010", manufactured by Ciba Japan K.K.).

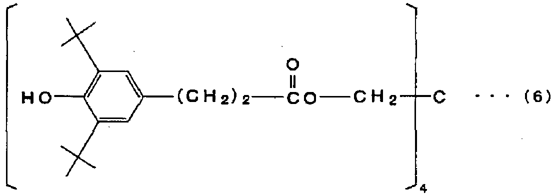

In a case where a light stabilizer is incorporated to the adhesive layer, if the content is too small, the effect of its addition cannot be sufficiently obtained, and if it is too large, the light stabilizer itself tends to cause yellowing or hinder the curing. Therefore, its content is preferably set within a range wherein no such a trouble will be caused. For example, its content is preferably from 0.1 to 4.0 parts by mass, more preferably from 0.5 to 2.0 parts by mass, per 100 parts by mass of the solid content of a two-pack reactive polyurethane adhesive of the present invention.

### [Other components]

In addition to the above polyurethane resin (A), curing agent (B), ultraviolet absorber (C) and light stabilizer (D), the adhesive composition of the present invention may contain components other than the above polyurethane resin (A), curing agent (B), ultraviolet absorber (C) and light stabilizer (D), as the case requires, within a range not to impair the effects of the present invention.

Such other components may be adhesion promoters. The adhesion promoters may, for example, be coupling agents such as a silane coupling agent, a titanate type coupling agent, an aluminum type coupling agent, etc., epoxy resins, etc. Among them, a silane coupling agent is preferred.

The silane coupling agent may, for example, be an amino silane such as γ-aminopropyltriethoxysilane, γ-aminopropyltrimethoxysilane, N-β(aminoethyl)-γ-aminopropyltrimethoxysilane, N-β(aminoethyl)-γ-aminopropyltrimethyldimethoxysilane or N-phenyl-γ-aminopropyltrimethoxysilane; an epoxy silane such as β-(3,4-epoxycyclohexyl)ethyltrimethoxysilane, γ-glycidoxypropyltrimethoxysilane or γ-glycidoxypropyltriethoxysilane; a vinyl silane such as vinyl tris(β-methoxyethoxy)silane, vinyl triethoxysilane, vinyl trimethoxysilane or γ-methacryloxypropyltrimethoxysilane; hexamethyl disilazane, or γ-mercaptopropyltrimethoxysilane. Among them, an epoxy silane such as γ-glycidoxypropyltrimethoxysilane or γ-glycidoxypropyltriethoxysilane is preferred.

Further, other components may, for example, be a resin other than the polyurethane resin (A), an ultraviolet absorber other than the ultraviolet absorber (C), a catalyst for reaction, a defoaming agent, a leveling agent, an antioxidant, etc.

Here, the resin contained in the adhesive composition of the present invention is preferably solely the polyurethane resin (A). Further, the ultraviolet absorber contained in the adhesive composition of the present invention is preferably solely the ultraviolet absorber (C).

The adhesive composition of the present invention may be made to be a two-pack curing system wherein a base resin containing the polyurethane resin (A), and the curing agent (B), are separated, or, for example, in a case where the curing agent is a blocked isocyanate, it may be made to be a one-pack curing system containing the polyurethane resin (A) and the curing agent (B) together. In a case where the adhesive composition of the present invention is made to be a two-pack curing system, the ultraviolet absorber (C), the light stabilizer (D) and other components, may be contained in the base resin containing the polyurethane resin (A), or may be mixed to the curing agent (B).

With respect to the proportions of the polyurethane resin (A) and the curing agent (B) in the adhesive composition of the present invention, the equivalent ratio NCO/OH of isocyanate groups in the curing agent (B) to hydroxy groups in the polyurethane resin (A) is adjusted to be preferably from 1.0 to 5.0, more preferably from 1.5 to 4.0. When such NCO/OH is at least the lower limit value, the curing reaction of the adhesive composition tends to readily proceed. When such NCO/OH is at most the upper limit value, a curing failure tends to scarcely occur, and the curing can be completed in a short time.

The content of the ultraviolet absorber (C) in the adhesive composition varies depending upon the thickness of the adhesive layer to be formed, but it is usually preferably from 4 to 11 parts by mass, more preferably from 5 to 9 parts by mass, per 100 parts by mass of the solid content of the polyurethane resin (A) of the present invention. When the content of the ultraviolet absorber (C) is at least the lower limit value, the weather resistance will be improved. When the content of the ultraviolet absorber (C) is at most the upper limit value, it is easy to prevent a decrease in the adhesive force.

The content of the light stabilizer (D) in the adhesive composition is preferably from 0.2 to 5 parts by mass, more preferably from 0.5 to 2.5 parts by mass, per 100 parts by mass of the solid content of the polyurethane resin (A). When the content of the light stabilizer (D) is at least the lower limit value, it becomes easy to prevent the heat deterioration and the light deterioration of the ultraviolet absorber. When the content of the light stabilizer (D) is at most the upper limit value, it is possible to prevent the adhesive layer from becoming opaque due to a low solubility of the light stabilizer at a low temperature of about -30°C.

The total concentration of the solid content (non-volatile content) in the adhesive composition of the present invention is preferably from 5 to 50 mass%, more preferably from 10 to 35 mass%, in a state where all components are contained, i.e. in a state at the time of practical use. Here, in a case where the adhesive composition of the present invention is made to be a two-pack curing system, "the state where all components are contained" means such a state that, at the time of practical use, the base resin and the curing agent are mixed, and further, a solvent is added in order to adjust the viscosity to the optimum level for e.g. gravure coating.

More specifically, in a case where the adhesive composition of the present invention is made to be a two-pack curing system, it is preferred that the base resin having a solid content concentration of from 20 to 80 mass% and the curing agent (B) having a solid content concentration of from 40 to 100 mass%, are mixed, and, as the case requires, the mixture is diluted with a diluting solvent for use.

With the adhesive composition of the present invention, a laminate may be prepared by the same method as for a so-called dry lamination adhesive wherein it is applied to a film in the same manner as for a usual ink or adhesive, and after drying it at from 70 to 120°C for from 10 seconds to 120 seconds, lamination is carried out. In the case of gravure coating, the viscosity by Zahn cup No. 3 is preferably from 10 seconds to 35 seconds, more preferably from 15 seconds to 30 seconds, and therefore, the solid content concentration is so adjusted by a solvent.

Heretofore, as an adhesive whereby a high adhesive strength is obtainable to various elastomers or plastic substrates, a two-pack curing adhesive is known wherein a polyester type base resin, polyesterpolyurethane type base resin or polyetherpolyurethane type base resin having hydroxyl groups at its terminals, and a polyisocyanate curing agent are to be blended. However, such an adhesive may sometimes be inadequate in heat and humidity resistance and long-term durability represented by weather resistance, etc. during long-term exposure, which are required for e.g. electric or electronic materials, automobile components, artificial leathers, building materials, etc., and its adhesive strength tends to be decreased by long-term exposure.

Whereas, the adhesive layer formed by the adhesive composition of the present invention contains, as a base resin, the polyurethane resin (A) made of the polycarbonate polyol (a1) as the starting material, and, as an ultraviolet absorber, the specific ultraviolet absorber (C) and the light stabilizer (D), whereby it is possible to maintain an excellent ultraviolet absorbing function over a long period of time, and the adhesion force is scarcely decreased even in a moist environment.

The adhesive composition of the present invention is suitable for an application to prevent deterioration, by ultraviolet light, of an object to be coated, particularly suitable for an application to be used outdoors. Specifically, it can be suitably used for an application e.g. as a protective film for various printed matters or displays, or as a front surface material and a rear surface material of a solar cell module. It is particularly useful for a laminate of a fluororesin film to permeate light in an ultraviolet region.

### [Laminate]

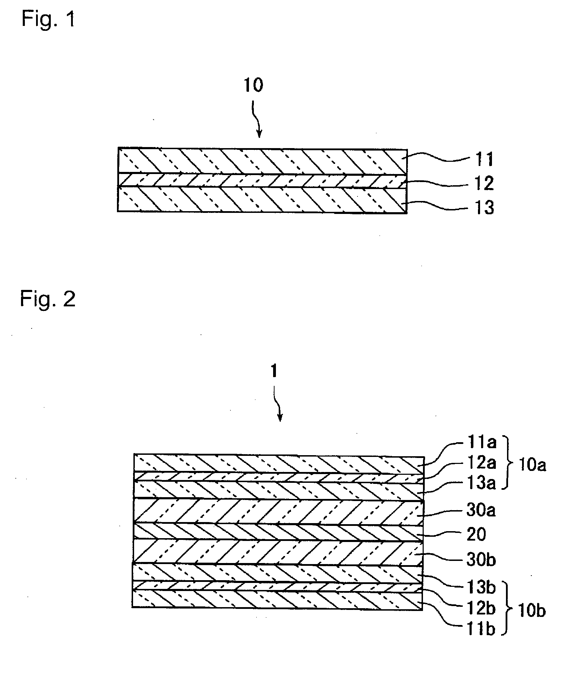

The laminate of the present invention comprises a substrate made of a fluororesin film, and an adhesive layer formed of the above-described adhesive composition of the present invention on the substrate. Now, it will be described in detail with reference to one embodiment of the laminate of the present invention. Fig. 1 is a cross-sectional view illustrating a laminate 10 as one embodiment of the laminate of the present invention.

As shown in Fig. 1, the laminate 10 has a first substrate 11, an adhesive layer 12 and a second substrate 13 laminated in this order. The laminate 10 is to be used so that the first substrate 11 faces outside.

### [Substrates]

The first substrate 11 is a substrate made of a fluororesin film.

The fluororesin to constitute the first substrate 11 may, for example, be an ethylene/tetrafluoroethylene copolymer (hereinafter referred to as "ETFE"), a hexafluoropropylene/tetrafluoroethylene copolymer (hereinafter referred to as "FEP"), a perfluoro(alkyl vinyl ether)/tetrafluoroethylene copolymer (hereinafter referred to as "PFA", a tetrafluoroethylene/hexafluoropropylene/vinylidene fluoride copolymer (hereinafter referred to as ""THV"), a polyvinylidene fluoride, a vinylidene fluoride/hexafluoropropylene copolymer, or a polyvinyl fluoride. Among them, at least one member selected from the group consisting of ETFE, FEP, PFA and THV is preferred, and ETFE is particularly preferred.

The first substrate 11 may suitably contain known additives, etc. within a range not to impair the effects of the present invention. For example, it may be a fluororesin film containing an ultraviolet absorber.

The thickness of the first substrate 11 may suitably be set depending upon the particular application, and it is preferably at least 10 µm, more preferably at least 20 µm, from the viewpoint of handling efficiency. The upper limit value for the thickness of the first substrate 11 is preferably 1 mm. Further, in a case where the first substrate 11 is used as a protective film, the thickness of the first substrate 11 is preferably at least 12 µm, more preferably at least 20 µm.

In the first substrate 11, the surface on which the adhesive layer 12 is laminated, is preferably preliminarily subjected to surface treatment so that the surface wetting index is adjusted to be at least 35 mN/m, preferably at least 40 mN/m. The method for such surface treatment may, for example, be corona discharge treatment (e.g. in air, in nitrogen or in carbon dioxide gas), plasma treatment (high pressure or low pressure), alkali metal solution treatment or radio-frequency sputtering/etching treatment.

Here, in the present invention, the surface wetting index means a value which is measured by a method in accordance with JIS K6768 by means of a wetting index reagent.

The second substrate 13 may, for example, be a biaxially-stretched polypropylene film; an ethylene/vinyl acetate copolymer (EVA) film; a polyethylene naphthalate (PEN) film; a polyethylene terephthalate (PET) film; a nylon film; an alumina-vapor deposited or silica-vapor deposited biaxially-stretched polypropylene film; a film obtained by laminating base films selected from EVA, PET, nylon and PEN on one another; or a laminated film obtained by laminating such a base film and a sealant film selected from polyethylene, polypropylene, aluminum-vapor deposited polyethylene and polypropylene. To the above base film, printing may be applied.

Further, it may be an aluminum-vapor deposited film, an alumina-vapor deposited film, a silica-vapor deposited film, an aluminum foil or the like. Further, it may be the same fluororesin film as the first substrate 11.

Here, a substrate which is classified into a soft vinyl chloride resin containing a large amount of a plasticizer, should better be not used for the second substrate 13, since the adhesion tends to be hardly obtainable.

In the second substrate 13 like in the first substrate 11, the surface on which the adhesive layer 12 is laminated, is preferably preliminarily subjected to surface treatment so that the surface wetting index of the surface is adjusted to be at least 35 mN/m, preferably at least 40 mN/m.

The thickness of the second substrate 13 may suitably be set.

### [Adhesive layer]

The adhesive layer 12 is a layer formed of the above-described adhesive composition of the present invention. Via the adhesive layer 12, the first substrate 11 and the second substrate 13 are bonded.

The thickness of the adhesive layer 12 is preferably from 3 to 20 µm, more preferably from 5 to 10 µm.

The process for producing the laminate 10 may, for example, be a lamination process which comprises a step of applying the adhesive composition to the first substrate 11, a step of drying the applied adhesive composition, and a step of laminating the second substrate 13 on the surface of the first substrate 11 having the adhesive composition applied, and curing the adhesive composition to form the adhesive layer 12.

The method for applying the adhesive composition is not particularly limited, and a gravure roll coating method may, for example, be mentioned.

The method for drying the adhesive composition may, for example, be a method for drying by means of a drier. The drying temperature is preferably from 70 to 120°C.

As a method for laminating the second substrate 13 on the surface of the first substrate 11 having the adhesive composition applied, a conventional optional method may be adopted. For example, a method of using a laminate roll may be mentioned. The temperature of the laminate roll is preferably from 40 to 120°C.

Aging after curing the adhesive composition is carried out preferably from 40 to 70°C for from 2 to 168 hours.

The adhesive layer of the laminate of the present invention is excellent in the weather resistance, whereby an excellent ultraviolet absorbing function can be maintained over a long period of time, and even in a moist environment, the adhesive force is scarcely decreased. Therefore, it is suitable for an application to prevent deterioration, due to ultraviolet light, of a layer inside of the adhesive layer, particularly suitable for an application to be used outdoors. Specifically, it is suitable as a protective film for various printed matters or displays, or as a front surface material and a rear surface material of a solar cell module.

Further, the laminate of the present invention is not limited to the above laminate 10. For example, it may be a laminate having at least one substrate laminated via an adhesive layer on the second substrate 13. In such a case, with a view to further improving the weather resistance, it is preferred to form also the adhesive layer on the second substrate 13 by the adhesive composition of the present invention. However, from the viewpoint of saving the costs, it is preferred to form the adhesive layer on the second substrate 13 by an adhesive composition not containing an ultraviolet absorber (C) or a light stabilizer (D).

### [Solar cell module]

The solar cell module of the present invention is a solar cell module having the laminate of the present invention, as at least one of a front surface material and a rear surface material.

In the solar cell module of the present invention, it is preferred that the front surface material disposed on the light incidence side, has the laminate of the present invention. Further, it is particularly preferred that both the front surface material disposed on the light incidence side and the rear surface material disposed on the opposite side to the light incidence side, have the laminate of the present invention.

Now, the solar cell module of the present invention will be described in detail with reference to one embodiment thereof.

As shown in Fig. 2, the solar cell module 1 of this embodiment has a filler 30a and a laminate 10a as a front surface material laminated in this order on the light incidence side of a solar cell 20, and has a filler 30b and a laminate 10b as a rear surface material laminated in this order on the opposite side to the light incidence side.

The laminate 10a has a first substrate 11a, an adhesive layer 12a and a second substrate 13a laminated in this order. The modes of the respective components of the laminate 10a are the same modes as of the above-described laminate 10, and the preferred modes are also the same. The laminate 10a is the front surface material of the solar cell module 1 and is disposed so that the first substrate 11 a faces outside.

The laminate 10b has a first substrate 11 b, an adhesive layer 12b and a second substrate 13b laminated in this order. The modes of the respective components of the laminate 10b are the same modes as of the above-described laminate 10, and the preferred modes are also the same. The laminate 10b is the rear surface material of the solar cell module 1 and is disposed so that the first substrate 11 b faces outside.

As the solar cell 20, a known solar cell may be used, and it may, for example, be a cell which comprises a thin film photoelectric conversion layer of amorphous silicon (a-Si) having a high collection efficiency for light of a short wavelength side, as a top cell, and a thin film photoelectric conversion layer of amorphous silicon-germanium (a-SiGe) having a high collection efficiency for light of a long wavelength side, as a bottom cell, wherein a laminate of the top cell and the bottom cell is disposed between a pair of electrically conductive layers. Further, another solar cell may, for example, be of a type having a photoelectric conversion layer of an alloy of copper-indium-gallium-selenium (CIGS) or copper-indium-selenium (CIS), or of a so-called organic solar cell type such as a cadmium-tellurium type (CdTe), cadmium-sulfur type (CdS), p-n junction type or pi-n junction type semiconductor.

As the filler 30a or 30b, a known filler may be used, and it may, for example, be an ethylene/vinyl acetate copolymer (EVA) sheet.

The solar cell module 1 can be produced by a known method such as a lamination method, provided that the laminate 10a and the laminate 10b are used as the front surface material and the rear surface material, respectively.

The solar cell module of the present invention as described in the foregoing has an excellent weather resistance, since it employs the laminate of the present invention having an adhesive layer that is capable of maintaining a high adhesive force and an excellent ultraviolet absorbing function over a long period of time, as at least one of the front surface material and the rear surface material.

### EXAMPLES

Now, the present invention is described in detail with reference to Examples, but it should be understood that the present invention is by no means restricted by the following description. Examples 1 to 18 are working Examples of the present invention, and Examples 19 to 39 are Comparative Examples.

### [Components used]

Components used in Examples of the present invention and Comparative Examples are as follows.

### (Polyurethane resin (A))

### HD-1013:

Trade name "HD-1013" (solid content: 60 mass%, manufactured by Rock Paint Co., Ltd.) A polyurethane resin obtainable by reacting 1,6-pentane diol as the chain extender (a2) and isophorone diisocyanate (IPDI) as the organic diisocyanate (a3), to a polycarbonate diol made of 3-methyl-1,5-pentane diol as a starting material, as the polycarbonate polyol (a1). Further, as a tackifier, γ-glycidoxypropyltriethoxysilane is contained.

### A-1102:

Trade name "Takerack A-1102" (solid content: 50 mass%, manufactured by Mitsui Chemicals, Inc.) A polyurethane resin obtainable by reacting IPDI as the organic diisocyanate (a3), to a polycarbonate diol made of 1,6-hexane diol as a starting material, as the polycarbonate polyol (a1). Further, as a tackifier, γ-glycidoxypropyltriethoxysilane is contained.

### (Curing agent (B))

### H-62:

Trade name "H-62" (isocyanate content: 10 mass%, solid content: 75 mass%, manufactured by Rock Paint Co., Ltd.) A nurate containing IPDI and hexamethylene diisocyanate (HDI) as main components, and the solvent is ethyl acetate.

### A-3070:

Trade name "Takenate A-3070" (isocyanate content: 15 mass%, solid content: 75 mass%, manufactured by Mitsui Chemicals, Inc.) A nurate containing HDI as a main component, and the solvent is ethyl acetate.

### (Other resins (X))

### NT-258:

Trade name "Crisbon NT-258" (solid content: 50 mass%, manufactured by DIC Corporation) A polyurethane resin obtained by reacting sebacic acid, isophthalic acid, neopentyl glycol and isophorone diisocyanate.

### AD-76P1:

Trade name "AD-76P1" (manufactured by Toyo-Morton, Ltd.) A polyester resin having a solid content of 55 mass%, obtained by epoxy-modifying, with bisphenol A, terminals of a polyester resin made of suberic acid, isophthalic acid, terephthalic acid and ethylene glycol.

### A-515:

Takerack A-515 (polyesterpolyol, solid content: 60 mass%, manufactured by Mitsui Chemicals, Inc.)

### (Curing agent (Y))

### 2096:

Trade name "Coronate 2096" (manufactured by Nippon Polyurethane Industry Co., Ltd.) An aliphatic hexamethylene diisocyanate having a solid content of 90 mass%.

### CAT10:

Trade name "CAT10" (manufactured by Toyo-Morton, Ltd.) An aromatic tolylene diisocyanate having a solid content of 75 mass%.

### A-50:

Trade name "Takenate A-50" (xylene diisocyanate, solid content: 75 mass%, manufactured by Mitsui Chemicals, Inc.)

### (Ultraviolet absorber (C))

### TINUVIN 479:

Trade name "TINUVIN 479" (hydroxyphenyltriazine type ultraviolet absorber, Ciba Japan K.K.)

### TINUVIN 477:

Trade name "TINUVIN 477" (hydroxyphenyltriazine type ultraviolet absorber, Ciba Japan K.K.)

### (Other ultraviolet absorber (Z))

### TINUVIN PS:

Trade name "TINUVIN PS" (benzotriazole type ultraviolet absorber, Ciba Japan K.K.)

### (Light stabilizer (D))

### HALS 123:

Trade name "TINUVIN 123" (hindered amine type light stabilizer, Ciba Japan K.K.)

### [Example 1]

100 parts by mass (solid content) of HD-1013 as the polyurethane resin (A) being the base resin, 18.8 parts by mass (solid content) of H-62 as the curing agent (B), 7 parts by mass of TINUVIN 479 as the ultraviolet absorber (C) and 1.5 parts by mass of HALS 123 as the light stabilizer, were mixed to prepare an adhesive composition.

On a corona discharge-treated surface of an ETFE film (trade name: Aflex, manufactured by Asahi Glass Company Limited) having a thickness of 25 µm and having corona discharge treatment applied, the above adhesive composition was applied by an applicator so that the coating thickness after drying would be 5 µm. Then, after drying at 70°C for 2 minutes by a drier, as the other material an ETFE film (trade name: Aflex, manufactured by Asahi Glass Company Limited) having a thickness of 25 µm and having the same corona discharge treatment as above applied, was press-bonded by a lamination roll having a nipping temperature maintained at 70°C, followed by aging at 40°C for 48 hours to obtain a laminate. Of the ETFE film as the other material, the corona discharge-treated surface was the surface in contact with the adhesive composition. Further, the corona discharge-treated surface of each ETFE film had a surface wetting index adjusted to be 40 mN/m. The surface wetting index was measured in accordance with JIS K6768 by means of a wetting index reagent manufactured by Wako Pure Chemical Industries, Ltd.

The obtained laminate was used for evaluation of the weather resistance as described hereinafter.

### [Examples 2 to 39]

A laminate was prepared in the same manner as in Example 1 except that the composition and coating thickness of the adhesive composition, and the type of the other material to be laminated on the ETFE film having the adhesive composition applied, were changed as shown in Tables 1 to 3, and used for evaluation of the weather resistance as described hereinafter.

As the other material other than the ETFE film, Teijin Polyester Film TYPE G2C (corona-treated product, manufactured by Teijin Corporation) being a PET film having a thickness of 25 µm, was used, and the corona discharge-treated surface was the surface in contact with the adhesive composition.

### [Evaluation methods]

With respect to the laminate obtained in each Example, the initial ultraviolet transmittance for a wavelength of 360 nm, color difference (change in yellowness index) and adhesive force, and the ultraviolet transmittance for a wavelength of 360 nm, color difference and adhesive force, after the following damp heat test and weather-o-meter test, were measured and evaluated.

### (Damp heat test)

The obtained laminate was subjected to a damp heat test at a temperature of 85°C under a relative humidity of 85% for 1,000 hours.

### (Weather-O-Meter test (SWM test))

The obtained laminate was subjected to an exposure test in accordance with JIS A1415 "Method for exposure test of polymer-type building material by laboratory light source" by means of a weather-o-meter tester (trade name: 300 Sunshine Weather Meter, Suga Test Instruments Co., Ltd.). The light source was a sunshine carbon-arc lamp and was operated at an irradiance of 255 W/m² (from 300 to 700 nm) at a BPT (black panel temperature) of 63°C, and one cycle for 60 minutes in total consisting of light irradiation for 48 minutes, and light irradiation and rainfall for 12 minutes, was repeated for 1,000 hours. As the exposure mode, such an exposure mode that light and water are applied to the ETFE film surface, was adopted.

### (Ultraviolet transmittance)

With respect to the laminate in each Example, the ultraviolet transmittance (unit: %) for a wavelength of 360 nm was measured by means of UV-3600 measuring apparatus manufactured by Shimadzu Corporation. Here, before forming into a laminate, the ultraviolet transmittance for a wavelength of 360 nm, of the ETFE film having a thickness of 25 µm alone, was 93%, and the ultraviolet transmittance for a wavelength of 360 nm, of the PET film having a thickness of 25 µm alone, was 88%. The lower the ultraviolet transmittance of the laminate, the higher the ultraviolet absorbing function of the adhesive layer. If it is possible to suppress the ultraviolet transmittance for a wavelength of at most 360 nm to be preferably within 20%, more preferably within 10%, it is possible to prevent deterioration by light of most plastic materials.

### (Color difference: Change in yellowness index (ΔY·I))

With respect to the laminate in each Example, the color difference based on the damp heat test and the weather-o-meter (SWM) test, was evaluated by measuring the change in yellowness index (ΔY·I) by a transmission measuring method in accordance with JIS Z8722 by means of SM-T color meter manufactured by Suga Test Instruments Co., Ltd. The smaller the ΔY·I, the less the coloration (yellowing).

### (Adhesive force)

The adhesive force of the laminate in each Example was evaluated by measuring the peel strength (180° peel strength, peeling speed: 60 cm/min.) (unit: N/cm).

### (Comprehensive evaluation)

Comprehensive evaluation of the weather resistance is as follows.
"○ (good)": After 1,000 hours in the above damp heat test and weather-o-meter (SWM) test, the adhesive force is at least 3 N/cm, ΔY·I is 1 or less, and the change in the ultraviolet transmittance for a wavelength of 360 nm is 10% or less.
" × (no good)": After 1,000 hours in the above damp heat test and weather-o-meter (SWM) test, at least one of such conditions that the adhesive force is at least 3 N/cm, ΔY·I is 1 or less, and the change in the ultraviolet transmittance for a wavelength of 360 nm is 10% or less, is not satisfied.

When the adhesive force is at least 3N/cm and ΔY·I is 1 or less, such a laminate is regarded as one having the adhesive force well maintained and having a color change minimized. This is an essential evaluation item particularly with respect to a back sheet for a solar cell. Further, not only the change in color of the laminate, but also the ultraviolet transmittance for a wavelength of 360 nm was evaluated. In this test, the ultraviolet transmittance is considered to be changed by hygrothermal aging of the adhesive layer or the PET film or by volatilization by heat of the ultraviolet absorber.

The evaluation results in each Example are shown in Tables 1 to 3. Further, the blend amount of each component in the adhesive composition shown in Tables 1 to 3 is the mass (unit: parts by mass) of the solid content. Further, one evaluated to be "rupture" after the accelerated weather test, means that the PET film was fractured and ruptured.

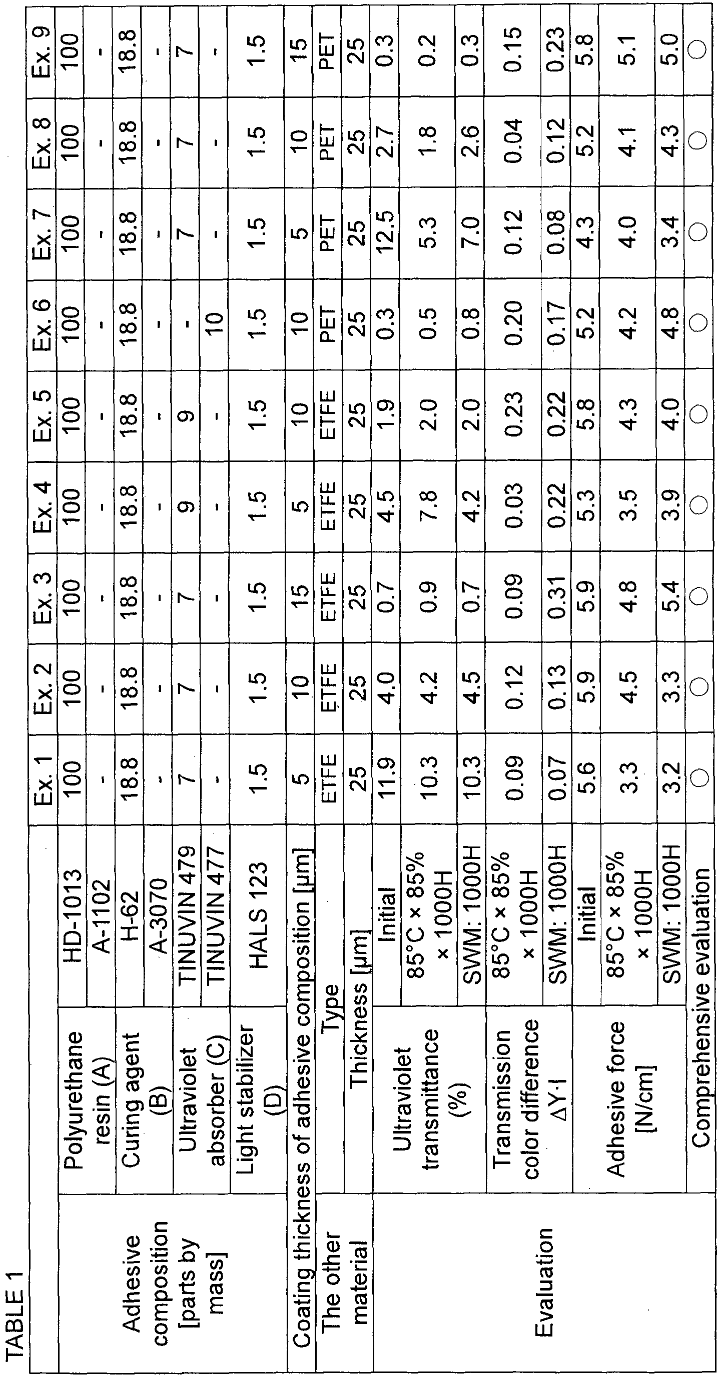

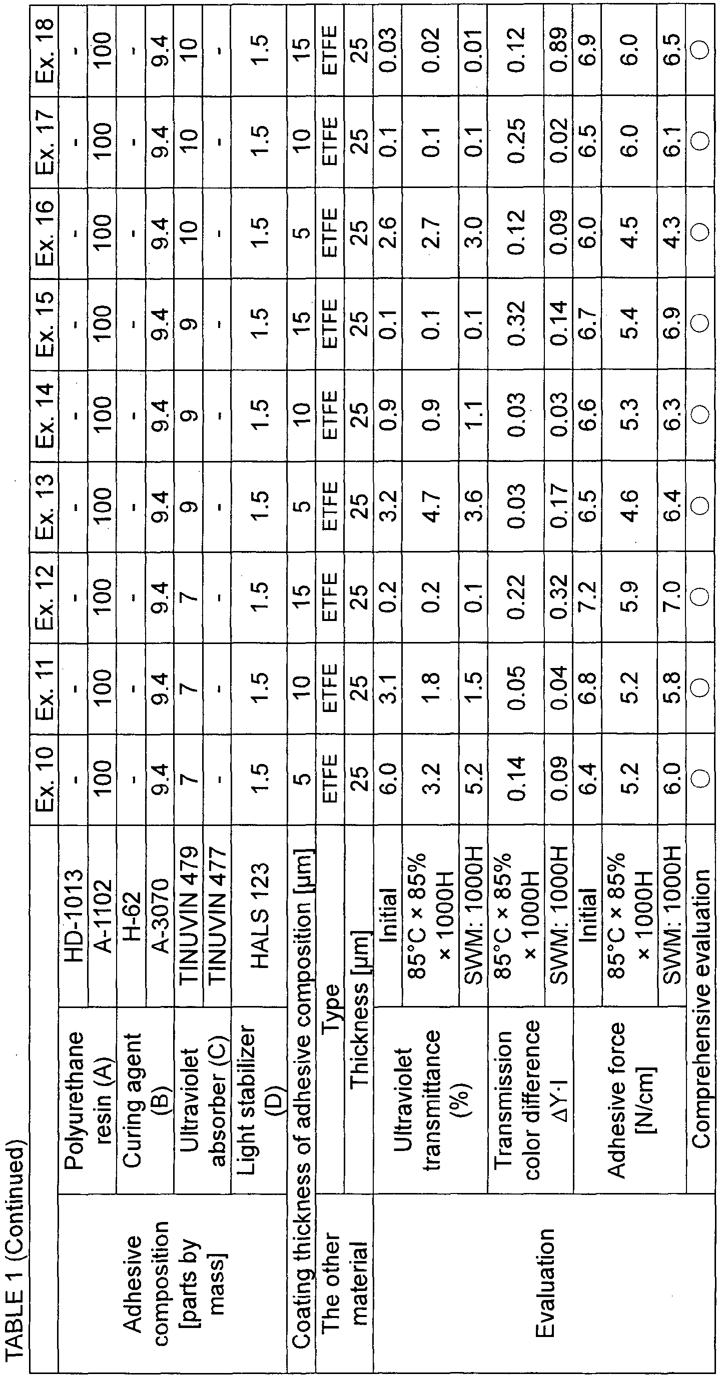

**TABLE 2**

| | | | Ex. 19 | Ex. 20 | Ex. 21 | Ex. 22 | Ex. 23 | Ex. 24 | Ex. 25 | Ex. 26 | Ex. 27 | Ex. 28 | Ex. 29 | Ex. 30 | Ex. 31 |
|---|---|---|---|---|---|---|---|---|---|---|---|---|---|---|---|
| Adhesive composition [parts by mass] | Polyurethane resin (A) | HD-1013 | 100 | 100 | 100 | 100 | 100 | - | - | - | - | - | - | - | - |
| | | A-1102 | - | - | - | - | - | 100 | 100 | 100 | - | - | - | - | - |
| | Other resin (X) | NT-258 | - | - | - | - | - | - | - | - | 100 | 100 | 100 | 100 | 100 |
| | Curing agent (B) | H-62 | 18.8 | 18.8 | 18.8 | 18.8 | 18.8 | - | - | - | - | - | - | - | - |
| | | A-3070 | - | - | - | - | - | 9.4 | 9.4 | 9.4 | - | - | - | - | - |
| | Curing agent (Y) | 2096 | - | - | - | - | - | - | | - | 15 | 15 | 15 | 15 | 15 |
| | Ultraviolet absorber (C) | TINUVIN 479 | - | - | - | - | - | - | - - | - | 7 | 7 | 7 | - | - |
| | Another ultraviolet absorber (Z) | TINUVIN PS | - | - | 1.5 | - | - | - | - | - | - | - | - | - | - |
| | Light stabilizer (D) | HALS 123 | - | - | 1.5 | - | - | - | - | - | 1.5 | 1.5 | 1.5 | - | - |
| Coating thickness of adhesive composition [µm] | | | 5 | 10 | 15 | 5 | 10 | 5 | 10 | 15 | 5 | 10 | 15 | 5 | 10 |
| The other material | Type | | ETFE | ETFE | ETFE | ETFE | ETFE | ETFE | ETFE | ETFE | ETFE | ETFE | ETFE | ETFE | ETFE |
| | Thickness [µm] | | 25 | 25 | 25 | 25 | 25 | 25 | 25 | 25 | 25 | 25 | 25 | 25 | 25 |
| Evaluation | Ultraviolet transmittance (%) | Initial | 87.3 | 87.5 | 0.6 | 86.8 | 86.6 | 87.9 | 88.1 | 87.7 | 10.8 | 5.5 | 0.5 | 86.2 | 84.6 |
| | | 85°C × 85% × 1000H | 84.5 | 80.5 | 78.2 | 81.4 | 80.5 | 83.4 | 81.5 | 80.1 | 10.2 | 5.2 | 0.6 | 81.4 | 81.2 |
| | | SWM: 1000H | 87.2 | 87.2 | 1.3 | Rupture | Rupture | 86.9 | 88.7 | 89.0 | 7.2 | 4.0 | 0.2 | 80.2 | 80.0 |
| | Transmission color difference ΔY·I | 85°C × 85% × 1000H | 0.04 | 0.01 | 0.10 | 0.20 | 0.34 | 0.09 | 0.10 | 0.06 | 1.5 | 1.6 | 1.7 | 0.9 | 0.8 |
| | | SWM: 1000H | 0.15 | 0.24 | 0.30 | Rupture | Rupture | 0.33 | 0.01 | 0.10 | 2.5 | 2.8 | 2.6 | 3.4 | 3.8 |
| | Adhesive force [N/cm] | Initial | 5.0 | 6.0 | 5.4 | 3.9 | 4.9 | 6.2 | 6.6 | 6.5 | 5.6 | 5.5 | 5.9 | 4.6 | 5.6 |
| | | 85°C × 85% × 1000H | 3.5 | 3.6 | 3.2 | 3.0 | 3.8 | 5.3 | 6.1 | 6.4 | 3.3 | 3.2 | 4.8 | 3.5 | 3.8 |
| | | SWM: 1000H | 1.3 | 1.6 | 3.7 | Rupture | Rupture | 1.0 | 1.3 | 1.5 | 2.0 | 1.9 | 1.8 | 0.7 | 0.7 |
| | Comprehensive evaluation | | × | × | × | × | × | × | × | × | × | × | × | × | × |

**TABLE 3**

| | | | Ex. 32 | Ex. 33 | Ex. 34 | Ex. 35 | Ex. 36 | Ex. 37 | Ex. 38 | Ex. 39 |
|---|---|---|---|---|---|---|---|---|---|---|
| Adhesive composition [parts by mass] | Other resin (X) | AD76P1 | 100 | 100 | 100 | 100 | 100 | - | - | - |
| | | A-515 | - | - | - | - | - | 100 | 100 | 100 |
| | Curing agent (Y) | CAT10 | 15 | 15 | 15 | 15 | 15 | - | - | - |
| | | A-50 | - | - | - | - | - | 14 | 14 | 14 |
| | Ultraviolet absorber (C) | TINUVIN 479 | 7 | 7 | 7 | - | - | 7 | 7 | 7 |
| | Light stabilizer (D) | HALS 123 | 1.5 | 1.5 | 1.5 | - | - | 1.5 | 1.5 | 1.5 |
| Coating thickness of adhesive composition [µm] | | | 5 | 10 | 15 | 5 | 10 | 5 | 10 | 15 |
| The other material | Type | | ETFE | ETFE | ETFE | ETFE | ETFE | ETFE | ETFE | ETFE |
| | Thickness [µm] | | 25 | 25 | 25 | 25 | 25 | 25 | 25 | 25 |
| Evaluation | Ultraviolet transmittance (%) | Initial | 8.5 | 4.2 | 0.1 | 80.0 | 78.5 | 6.5 | 3.2 | 0.1 |
| | | 85°C × 85% × 1000H | 8.2 | 3.5 | 0.1 | 72.6 | 70.0 | 5.5 | 2.5 | 0.1 |
| | | SWM: 1000H | 4.2 | 2.0 | 0.1 | 71.5 | 70.8 | 4.2 | 2.0 | 0.1 |
| | Transmission color difference ΔY·I | 85°C × 85% × 1000H | 0.9 | 0.8 | 0.7 | 1.5 | 1.6 | 0.9 | 0.9 | 1.0 |
| | | SWM: 1000H | 2.1 | 2.3 | 2.1 | 3.8 | 4.0 | 2.5 | 4.2 | 4.2 |
| | Adhesive force [N/cm] | Initial | 5.4 | 5.2 | 5.6 | 4.6 | 5.8 | 5.4 | 5.2 | 5.6 |
| | | 85°C × 85% × 1000H | 2.8 | 2.5 | 2.4 | 2.4 | 2.4 | 3.2 | 3.8 | 3.8 |
| | | SWM: 1000H | 0.6 | 0.5 | 0.4 | 0.3 | 0.3 | 0.6 | 1.2 | 2.0 |
| | Comprehensive evaluation | | × | × | × | × | × | × | × | × |

As shown in Tables 1 to 3, in each of Examples 1 to 18 representing the adhesive compositions of the present invention, the adhesive force and the color difference after expiration of 1,000 hours were good, and a high ultraviolet absorbing function was maintained in the weather-o-meter test and damp heat test, as compared with Examples 19 to 39 representing adhesive compositions other than the adhesive compositions of the present invention. Further, in Examples 1 to 3 wherein an ETFE film was used as the other material, and in Examples 6 to 9 wherein a PET film was used as the other material, similar results were obtained.

### INDUSTRIAL APPLICABILITY

The laminate wherein an adhesive layer formed of the adhesive composition of the present invention is laminated on a substrate made of a resin film such as a fluororesin film, is capable of maintaining a high adhesive force and an excellent ultraviolet-absorbing function for a long period of time and capable of preventing deterioration by ultraviolet light of an object to be covered, and thus is useful as a protective film for various printed matters or displays or as a surface material for solar cell modules.

The entire disclosure of Japanese Patent Application No. 2011-046184 filed on March 3, 2011 including specification, claims, drawings and summary is incorporated herein by reference in its entirety.

### REFERENCE SYMBOLS

1: Solar cell module
10, 10a, 10b: Laminate
11, 11a, 11b: First substrate
12, 12a, 12b: Adhesive layer
13, 13a, 13b: Second substrate
20: Solar cell
30a, 30b: Filler

## Claims

1. An adhesive composition comprising a polyurethane resin (A) made from a polycarbonate polyol (a1), a curing agent (B), a triazine-type ultraviolet absorber (C) and a light stabilizer (D).

2. The adhesive composition according to Claim 1, wherein the curing agent (B) includes an isocyanurate.

3. The adhesive composition according to Claim 1 or 2, wherein the triazine-type ultraviolet absorber (C) includes a hydroxyphenyltriazine type ultraviolet absorber.

4. The adhesive composition according to Claim 3, wherein the hydroxyphenyltriazine type ultraviolet absorber includes 2-(2-hydroxy-4-[1-octyloxycarbonylethoxy]phenyl)-4,6-bis(4-phenylphenyl)-1,3,5-triazine.

5. The adhesive composition according to any one of Claims 1 to 4, wherein the light stabilizer (D) includes a hindered amine type light stabilizer.

6. The adhesive composition according to any one of Claims 1 to 5, wherein the equivalent ratio NCO/OH of isocyanate groups in the curing agent (B) to hydroxy groups in the polyurethane resin (A) is from 1.0 to 5.0.

7. The adhesive composition according to any one of Claims 1 to 6, wherein the content of the triazine-type ultraviolet absorber (C) is from 4 to 11 parts by mass per 100 parts by mass of the solid content of the polyurethane resin (A).

8. The adhesive composition according to any one of Claims 1 to 7, wherein the content of the light stabilizer (D) is from 0.2 to 5 parts by mass per 100 parts by mass of the solid content of the polyurethane resin (A).

9. A laminate comprising a substrate made of a fluororesin film, and an adhesive layer formed of the adhesive composition as defined in any one of Claims 1 to 8, on the substrate.

10. The laminate according to Claim 9, wherein the fluororesin film is an ethylene/tetrafluoroethylene copolymer film.

11. A solar cell module having the laminate as defined in Claim 9 or 10, as at least one of a front surface material and a rear surface material.
